(19) Europäisches Patentamt / European Patent Office / Office européen des brevets

(11) **EP 3 629 457 B1**

(12) **EUROPEAN PATENT SPECIFICATION**

(45) Date of publication and mention
of the grant of the patent:
**02.11.2022 Bulletin 2022/44**

(21) Application number: **19197684.4**

(22) Date of filing: **17.09.2019**

(51) International Patent Classification (IPC):
***H02M 1/12*** *(2006.01)*     ***H02M 7/5387*** *(2007.01)*
***H03H 7/42*** *(2006.01)*

(52) Cooperative Patent Classification (CPC):
**H02M 1/126; H02M 7/5387;** H03H 7/427

(54) **POWER MODULE**

LEISTUNGSMODUL

MODULE D'ALIMENTATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.09.2018 CN 201811113723**

(43) Date of publication of application:
**01.04.2020 Bulletin 2020/14**

(73) Proprietor: **Delta Electronics, Inc.
Taoyuan City 33370 (TW)**

(72) Inventors:
• **YAN, Chao
33370 Taoyuan City (TW)**

• **SUN, Liping
33370 Taoyuan City (TW)**

(74) Representative: **SSM Sandmair
Patentanwälte Rechtsanwalt
Partnerschaft mbB
Joseph-Wild-Straße 20
81829 München (DE)**

(56) References cited:
**CN-A- 107 769 569     JP-A- 2003 168 586
JP-A- 2009 296 798     US-A1- 2008 112 121
US-A1- 2012 262 953     US-A1- 2018 205 309**

**Description**

FIELD OF THE INVENTION

The present invention relates to power modules, and particularly to a power module with low EMI (Electro-Magnetic Interference) noise.

BACKGROUND OF THE INVENTION

In recent years, SIC power semiconductor devices have been increasingly used in high-power power electronic converters due to their excellent switching characteristics. At present, the SIC power semiconductor devices can be a discrete component packaging, such as TO220, TO247, etc, and thereby the package is standardized, the cost is relatively low, and the reliability is relatively high. However, it also brings some problems, such as parasitic parameters (such as stray inductance) are relatively high and large EMI problems can exist in the case of large parasitic parameters application. Therefore, in some high power application, such as power of above 10KW, SIC power modules can be applied. The power module can significantly reduce internal parasitic parameters, and it is more suitable for usage of SIC die connected in parallel. Meanwhile, the driver of the power module utilizes the Kevin connection, and the power source and the driver source are completely isolated, thus the problem of common source does not exist and the switching loss can be reduced a lot. However, since the SIC device is a high-speed wide band-gap switch device, the voltage rise rate dv/dt and the current rise rate di/dt of the switching transistor are relatively high, thus the EMI noise is relatively large. There is the same problem as in all high-speed switching devices such as GaN.

US 2018/0205309 A1 discloses a single phase, non-insulated, miniaturized DC/AC power inverter having an output power density higher than 3000 W/dm3, wherein said first, second, third and fourth switches are made of wide-band semiconductors and preferably of gallium nitride or GaN semiconductors; and wherein said DC/AC power inverter further comprises: a ripple-compensating active filter comprising a third half-bridge having a fifth switch in series with a sixth switch, said fifth switch being connected at one end to the positive terminal of the DC input, said sixth switch being connected at one end to the negative terminal of the DC input, the other end of the fifth switch being connected to the other end of the sixth switch, defining a third common end, said third common end being connected to a first end of a LC filter, made of at least one inductor and one storage capacitor, a second end of the LC filter being connected to the negative terminal ; modulation control means of said first, second, third, fourth, fifth and sixth switches for providing a switch frequency comprised between 20 and 500 kHz and allowing variable phase shifts between any two of said first, second and third half-bridges and allowing dead time modulation of the switches of said half-bridges (201, 202, 203), so that to obtain a switching approaching ZVS switching, in particular to obtain switching when current crosses through zero and further to cancel switching losses and so that to allow high peak-to-peak voltage variations in the active filter, while storing corresponding energy in the storage capacitors, wherein the Y-capacitors of the common mode noise filter, are referenced to a shielding being at a reference potential, said shielding being insulated from earth, said Y-capacitors having a value comprised between 100 nF and several $\mu$F.

JP 2009 296798 A discloses: A power conversion apparatus is configured such that switching arms SA1, SA3, and SA4, each consisting of a series combination of at least two switching elements, are connected in parallel to each other and an AC power supply is connected to a middle point of each of at least two rows of switching arms SA1 and SA3. In the power conversion apparatus, a noise reducing means is provided which focuses on noise reduction processing with respect to the switching arm SA3 having a relatively small impedance connected to the middle point thereof out of the rows of switching arms.

JP 2003 168586 A discloses: The discharge lamp lighting device comprises an inverter circuit converting direct current supplied from a direct current power source into high frequency current, a choke coil connected to the inverter circuit, a discharge lamp load circuit composed of a discharge lamp and a coupling capacitor, a supplemental winding driving MOS FET's, a frequency detection means detecting oscillation frequency of MOS FET's, a frequency-voltage conversion means converting the frequency detected by the frequency detection means into a direct current voltage, and a control means controlling the current of the discharge lamp by changing the oscillation frequency of the MOS FET's, depending on the output of the frequency-voltage conversion means .

US 2012/262953 A1 discloses: A resonant power converter draws current from a source that provides a supply current. Multiple quasi-resonant converters are interleaved and each quasi-resonant converter receives the supply current and forms a phase-shifted current according to drive signals supplied by a controller. Each phase-shifted current includes a dead-time delay and is phase-shifted relative to the other phase-shifted currents. The dead-time delay is determined as a time value within a calculated dead-time delay range having a dead-time delay minimum and a dead-time delay maximum. The outputs of each quasi-resonant converter are added together thereby reducing the AC components of current. Two, three, or four quasi-resonant power converters can be interleaved, each forming phase-shifted currents that are phase-shifted relative to the other phase-shifted currents.

CN 107 769 569 A discloses a half-bridge flyback resonant circuit. The half-bridge flyback resonant circuit comprises a half-bridge circuit comprising an upper bridge arm and a lower bridge arm, wherein the upper bridge arm and the lower bridge arm are connected in series between an anode and a cathode of an input power, and the upper bridge arm and the lower bridge arm are respectively provided with switch elements which are used for switching on and off in turn; a primary input circuit being connected in parallel with the lower bridge arm and comprising an energy storage element and a primary winding of a flyback transformer, wherein a dotted terminal of the primary winding is connected between the upper bridge arm and the lower bridge arm, and a non-dotted terminal of the primary winding is connected with the cathode of the input power through the energy storage element; and a flyback secondary circuit configured to output an appropriate output voltage and comprising a secondary winding of the flyback transformer, wherein a non-dotted terminal of the secondary winding is taken as an anode outputting the output voltage, and a dotted terminal of the secondary winding is taken as a cathode outputting the output voltage. The half-bridge flyback resonant circuit improves the efficiency, reduces the cost, improves EMI, and is especially suitable for but not limited to a low-power source with high-voltage input and an auxiliary power source.

US 2008/112121 A1 discloses: A power supply device mounting structure includes a circuit board, which has two rows of pins arranged in parallel at the top side for power input and a bottom power connector connectable to a power connector on a motherboard for power output, and A DC-to-DC Power Module, which is connected to a power adapter for power input and has three rows of pins arranged in parallel at the power output side thereof and selectively electrically connectable with two rows of pins of the three rows of pins of the DC-to-DC power module to the two rows of pins of the circuit board for DC output to the circuit board and then the motherboard.

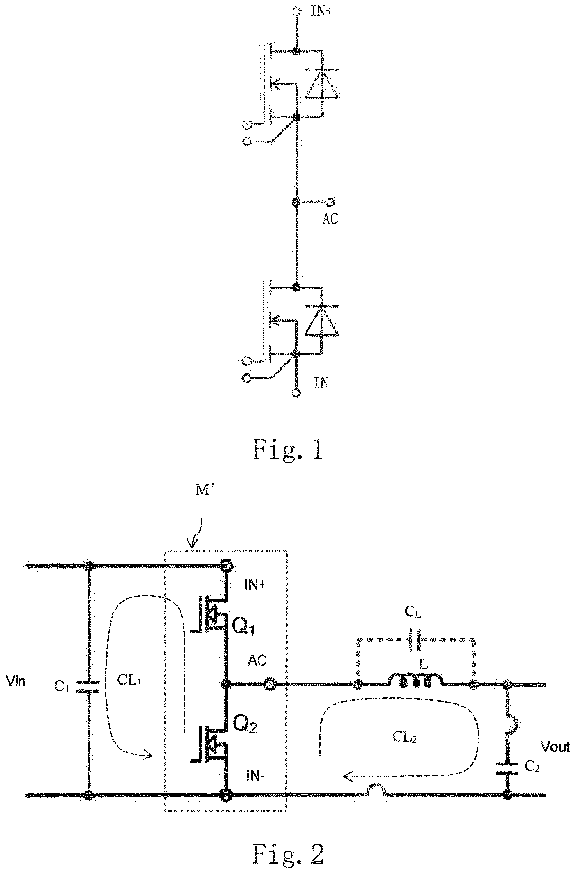

As shown Figure 1, in which a typical half-bridge power module is shown. The half-bridge power module have three power terminals, IN+, IN-, and AC, where the AC terminal is an EMI noise source. Moreover, the half-bridge power module includes a bridge arm having two semiconductors, by integrating the two semiconductors together, the length of the wires between the two semiconductors can be reduced, and the heat dissipation problem of the switches can be solved. Meanwhile, placing a high frequency capacitor outside and connected with the power terminals can reduce the switching peak and EMI noise.

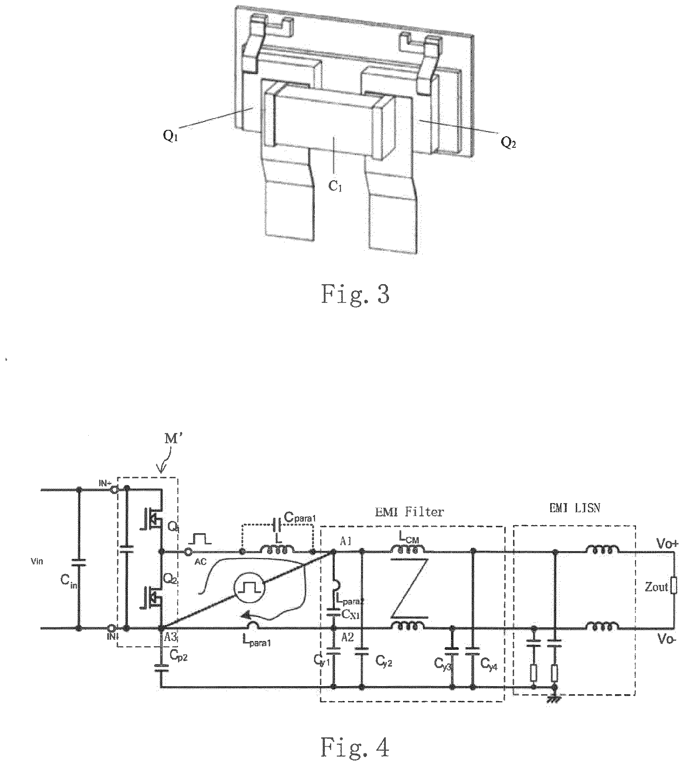

As shown Figure 2, in which shows a conventional buck circuit including a half-bridge power module. The power module M' includes a bridge arm having two power devices $Q_1$ and $Q_2$ connected in series, and has three power terminals of IN+, IN- and AC. The IN- and AC terminal are electrically connected to an inductor L and an output capacitor $C_2$, and the IN+ and IN- terminal are electrically connected to an input source Vin and an input capacitor $C_1$. However, due to the physical size of the power module M' itself, the stray inductance of the first loop $C_{L1}$, which includes power devices $Q_1$ and $Q_2$, and capacitor $C_1$, will be relatively large and thus affect EMC (Electro-Magnetic Compatibility) characteristics. In prior art, the high-frequency ceramic capacitor $C_1$ can be integrated inside the half-bridge power module and disposed at the position closest to the power terminals IN+ and IN- of the power devices $Q_1$ and $Q_2$ , as shown in Figure 3, which can greatly absorb excessive high voltage overshooting and therefore improves system reliability. However, the second loop $C_{L2}$ indicated in Figure 2 has a parasitic parallel capacitance $C_L$ of the output inductor L and a loop parasitic inductance (not shown), therefore the noise of high frequency on the AC terminal passes from the parasitic $C_L$ to the IN- terminal, which also causes high frequency EMC problems.

Specifically, as shown Figure 4, in which shows an EMI analysis circuit of a half-bridge power module M' applied in a typical buck circuit application, which includes a buck circuit, a primary EMI filter, an EMI LSIN, and an output impedance. Wherein $C_{para1}$ is the parasitic capacitor of the power inductor L. $L_{para1}$ is the parasitic inductance between a terminal A2 of capacitor $C_{X1}$ and the fixed point A3 of power module M', and $L_{para2}$ is the parasitic inductance between the point A1 and the capacitor Cxi.

Moreover, at high frequency, the impedance of the power inductor L is very large, while the impedance of the capacitor $C_{X1}$ is very small. The voltage across A1A2 and the voltage across A2A3 are approximately calculated as below:

$$V_{A1A2} = V_{noise} * ZL_{para2} / (ZL_{para1} + ZC_{para1} + ZL_{para2})$$

$$V_{A2A3} = V_{noise} * ZL_{para1} / (ZL_{para1} + ZC_{para1} + ZL_{para2})$$

Wherein, $V_{noise}$ is the noise voltage between the AC terminal and the IN-terminal. $ZL_{para1}$, $ZL_{para2}$, and $ZC_{para1}$ are the impedances of parasitic inductance $L_{para1}$, parasitic inductance $L_{para2}$, and parasitic capacitance $C_{para1}$, respectively. The voltage $V_{A1A2}$ of A1A2 is converted into differential mode noise, and the voltage $V_{A2A3}$ of A2A3 is converted into common mode noise. Given above, the higher the frequency is, the greater the impedance of the inductance (for example, the parasitic inductance $L_{para1}$ and the parasitic inductance $L_{para2}$) and the greater the noise are.

Therefore, there is an urgent need for a power module with low EMI noise.

SUMMARY OF THE INVENTION

In view of this, the present invention intends to provide a power module, which has low EMI noise and can greatly reduce engineers' time for solving EMI.

This purpose is solved by the features of device claim 1. The dependent claims recite advantageous embodiments of the invention.

The present invention adds at least one non-jumping power terminal based on the existing power module technology, and the non-jumping power terminal and a jumping power terminal configured to be respectively electrically connected to two terminals of a power inductor; and the present invention also adds a high frequency capacitor between the non-jumping power terminal and at least one of other non-jumping power terminals, therefore further reduces EMI noise and significantly saves engineers time for solving EMI.

The above description will be further described in detail below, as well as the further interpretation of the technical solution of the present invention will be provided

BRIEF DESCRIPTION OF THE DRAWINGS

To make the above and other objects, features, advantages and examples of the invention more apparent and straightforward, a brief description of the drawings is provided as follows:

Figure1 is a schematic diagram of the structure of a conventional half-bridge power module;

Figure 2 is a circuit schematic diagram of a conventional power module applied in the typical buck circuit;

Figure 3 is a schematic diagram of the structure of a power module of the existing integrated high frequency capacitors;

Figure 4 is a schematic diagram of an EMI analysis circuit of a conventional power module applied in a typical buck circuit;

Figure 5 is a schematic diagram of the structure of a power module according to a comparative embodiment.

Figures 6a-6c are voltage schematic diagrams of the non-jumping pin of Figure 5 with respect to a reference point;

Figure 7 is a schematic diagram of an EMI analysis circuit of a power module applied in a typical buck circuit according to a comparative embodiment.

Figure 8 is a waveform schematic diagram obtained by performing RFI testing of the power module under a first-stage EMI filter according to a comparative embodiment.

Figures 9a-9h are schematic diagrams of a topology circuit of a power module according to another comparative embodiment.

Figure 10 is a schematic diagram of an optimized circuit of a power module according to a preferred embodiment of the present invention.

DETAILED DESCRIPTION OF THE INVENTION

In order to make the description of the invention more elaborate and complete, reference may be made to the accompanying drawings and the various examples described below, and the same numbers in the drawings represent the same or similar components. On the other hand, well-known components and steps are not described in the examples to avoid unnecessarily limiting the invention. In addition, some of the conventional structures and elements already known are shown in the drawings in a simplified schematic manner to simplify the drawings.

The power module of the present invention has at least three non-jumping power terminals and at least one jumping power terminal. Wherein, the at least three non-jumping power terminals are at non-jumping potentials, and multiple power devices and at least one first capacitor are electrically connected between a first non-jumping power terminal and a second non-jumping power terminal. At least one jumping power terminal is at a jumping potential. A first jumping power terminal is electrically connected to one terminal of a power inductor and a third non-jumping power terminal is electrically connected to the other terminal of the power inductor. And at least one second capacitor are electrically connected between the third non-jumping power terminal and at least one of other non-jumping power terminals.

In the present invention, the "non-jumping potential" generally refers to a potential, which is at fixed potential or has tiny high-low level jumping with respect to a reference potential point. The tiny high-low level jumping can be, for example, a voltage rising rate dv/dt less than 2V/us. The "jumping potential" generally refers to having a large high-low level jumping with respect to the reference potential point. The large high-low level jumping can be, for example, the voltage rising rate dv/dt greater than 10 V/us. In one embodiment, the threshold values of the above voltage rising rate dv/dt, such as 2V/us or 10V/us, may also be variable fluctuate within a certain range, such as, but not limited to, ten percent, or five percent of 2V/us or 10V/us etc.

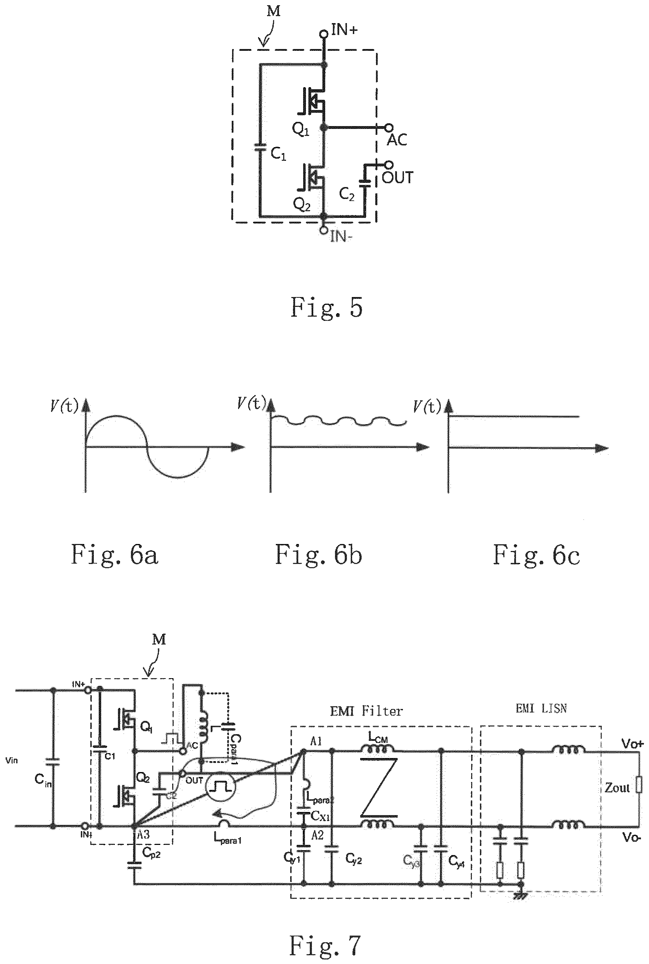

As shown Figure 5, in which shows a structure of a power module according to a comparative embodiment.

The power module M includes four power terminals, that is, terminals IN+, IN-, AC and OUT. Wherein terminals IN+, IN- and OUT are non-jumping power terminals at a non-jumping potential, and the terminal AC is jumping terminal at a jumping potential. In this embodiment, two power devices $Q_1$ and $Q_2$ and a capacitor $C_1$ are electrically connected between terminals IN+ and IN-. The above two power devices $Q_1$ and $Q_2$ are connected in series and configured as a bridge arm. The capacitor $C_1$ is connected in parallel with this bridge arm, and terminals AC and OUT are used to respectively electrically connect to both two terminals of a power inductor, and a capacitor $C_2$ is also electrically connected between terminals OUT and IN-.

In this embodiment, terminals IN+, IN-, AC, and OUT are respectively power terminals with current values greater than 1A. Wherein terminals IN+, OUT, and IN-are terminals at a fixed potential, for example, the terminal IN-serves as the reference point at a reference potential (such as a zero potential). Terminals IN+ and OUT are also at fixed potentials with respect to the terminal IN-, which is shown in Figure 6c. The terminal AC has a relative large high-low level jumping with respect to the terminal IN- (reference point), that is, there is a relative large voltage rising rate dv/dt between AC and IN- (for example, dv/dt > 10V/us), which is the noise source of EMI. In other embodiments, terminals IN+, OUT, and IN- may also be sinusoidal ripples superimposed with a frequency <10kHz, and the voltage rising rate dv/dt is relatively small, such as less than 2V/us, as shown in Figure 6b. In other embodiments, with respect to the terminal IN-, the terminal OUT also may also be provided with an AC voltage with a frequency <10kHz, which is also shown in Figure 6a.

Preferably, in an embodiment of the invention, the capacitors $C_1$, $C_2$ may be high frequency capacitors. More preferably, the capacitor $C_2$ can be a SMC or a capacitor die, and the value of the capacitor can be, for example, greater than 1nF.

As shown Figure 7, in which shows an EMI analysis circuit of a power module applied in a typical buck circuit according to a comparative embodiment. Wherein, with respect to the conventional power module M' shown in Figure 4, a power terminal OUT and a capacitor $C_2$ are added to the power module M of the present invention, and the capacitor $C_2$ is a high frequency capacitor with a parasitic inductance <1nH. The value of the capacitor $C_2$ is much larger than the parasitic capacitance $C_{para1}$ of the power inductor L. The parasitic inductances $L_{para1}$ and $L_{para2}$ are relatively small, so in high frequency, the impedance at both terminals of A1A2 is approximately equal to the impedance $ZC_2$ of the capacitor $C_2$ and the voltage $V_{A1A3}$ across A1A3 is approximated equals to $V_{noise}*ZC_2/(ZC_2+ ZC_{para1})$. Since $ZC_2$ is much smaller than $ZC_{para1}$, the noise amplitude at across A1A3 is significantly reduced.

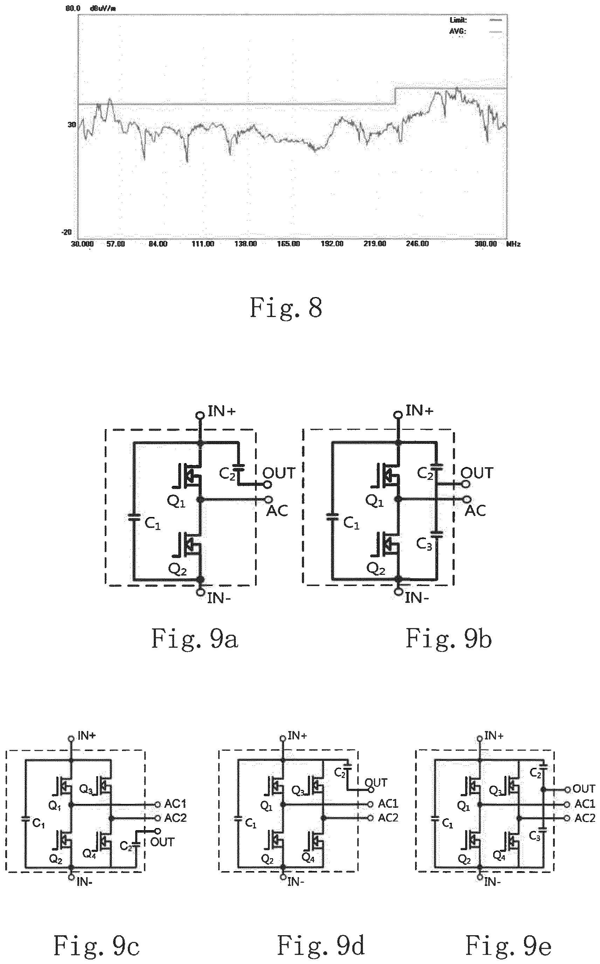

Figure 8 is a waveform schematic diagram obtained by performing RFI testing on the power module under a first-stage EMI filter according to a comparative embodiment. Using the connection mode of the power module of the present invention, the waveform of the RFI is obtained from the test under the topology of the high-speed switching device GaN, as shown in Figure 8. Seen from the waveform, the above power supply under first-level EMI filtering could satisfy the Class B standard.

It can be understood that the power module of the present invention is not limited to the above topology, and it can be widely applied to topologies such as boost, buck, Herric, and T-type three level, etc. At least one jumping node and at least three non-jumping nodes should be included in each topology. Moreover, the power terminal of the power module of the present invention in each topology should include both terminals of the power inductor and a non-jumping power terminal.

As shown Figure 9a to 9h, it shows topology circuits of the power modules according to other comparative embodiments.

As shown Figure 9a to 9b, the difference between the power module thereof and that shown in Figure 5 is that: in the power module shown in Figure 9a, the capacitor $C_2$ is electrically connected between terminals OUT and IN+; In the power module shown in Figure 9b, the capacitor $C_2$ is electrically connected between terminals OUT and IN+, and the capacitor $C_3$ is electrically connected between terminals OUT and IN-.

As shown in Figure 9c to Figure 9e, the difference between the power module thereof and that shown in Figure 5 is that: the power module shown in Figure 9c to Figure 9e includes two half-bridge arms between terminals IN+ and IN-, which respectively includes power devices $Q_1$ and $Q_2$ connected in series, and $Q_3$ and $Q_4$ connected in series. And terminals AC1 and AC2 terminal at a jumping potential are the center points of the two half-bridge arms respectively. Moreover, in the power module shown in Figure 9c, the capacitor $C_2$ is electrically connected between terminals OUT and IN-; in the power module shown in Figure 9d, the capacitor $C_2$ is electrically connected between terminals OUT and IN+. In the power module shown in Figure 9e, the capacitor $C_2$ is electrically connected between terminals OUT and IN+, and the capacitor $C_3$ is electrically connected between terminals OUT and IN-.

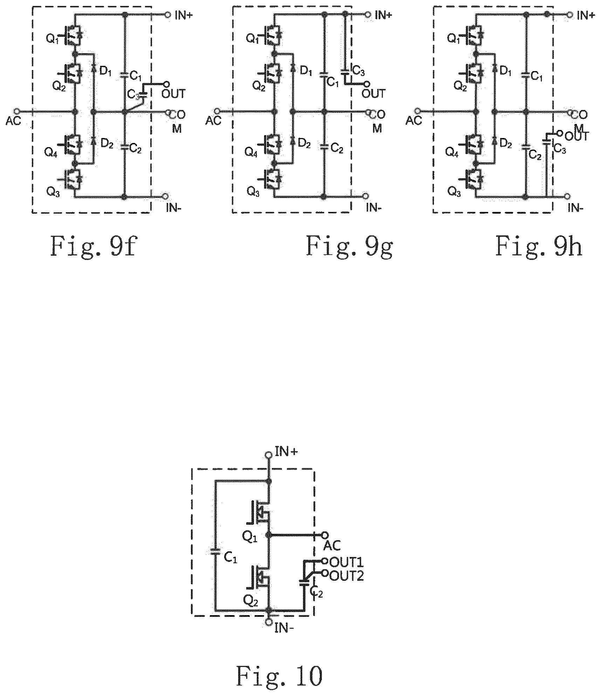

As shown in Figure 9f to Figure 9h, the difference between the power module thereof and that shown in Figure 5 is that: the power module shown in Figure 9f to Figure 9h includes a full-bridge arm between terminals IN+ and IN-, which includes power devices $Q_1$, $Q_2$, $Q_3$ and $Q_4$ connected in series. The power module further includes a first bridge arm having diodes $D_1$ and $D_2$ connected in series, which is connected in parallel with both terminals of the power devices $Q_2$ and $Q_3$. A second bridge arm having capacitors $C_1$ and $C_2$ connected in series is included between terminals IN+ and IN-, and the terminal COM at a non-jumping potential is a center point of the first bridge arm and the second bridge arm. Also, in the power module shown in Figure 9f, the capacitor $C_3$ is electrically connected between the terminal OUT and the second bridge arm. In the power module indicated in Figure 9g, the capacitor $C_3$ is electrically connected between terminals OUT and IN+ terminals. In the power module indicated in Figure 9h, the capacitor $C_3$ is electrically connected between terminals OUT and IN-.

As shown in Figure 10, in order to better optimize the effect of EMI, the present invention adds a power terminal OUT2 as an auxiliary terminal on the terminal of the capacitor $C_2$, and the terminal OUT2 is electrically connected to the OUT1 terminal. The terminals AC and OUT1 are configured to be electrically connected at both terminals of the power inductor (such as the power inductor L in Figure 7), and the terminal OUT2 is a non-jumping power terminal and is configured to be connected to one terminal of the external capacitor (such as capacitor $C_{X1}$ in Figure 7). This minimizes the equivalent inductance of $C_2$, and compared with the power module shown in Figure 5, EMI noise is less.

It can be understood that all the embodiments including the embodiment shown in Figure 9a to Figure 9h can change the output power terminal from one to two in the manner of Figure 10, and those are not considered as the limitation of the present invention. Moreover, when making the layout of the power module shown in Figure 5, in order to optimize EMI, one terminal of the power inductor and one terminal of the external capacitor may be respectively connected to the terminal OUT of the power module.

While the invention has been disclosed in the above implementations, it is not intended to limit the invention, and various modifications and retouches may be made by those skilled in the art without departing from the scope of the invention. The scope of protection of the invention therefore is subject to the scope defined by the appended claims.

**Claims**

**1.** A power module (M), comprising:

a bridge arm including multiple power devices ($Q_1$, $Q_2$; $Q_3$, $Q_4$) connected in series;
a first capacitor ($C_1$) connected in parallel with the bridge arm;
at least three non-jumping power terminals (IN+, IN-, OUT, OUT1) at a non-jumping potential, wherein a first non-jumping power terminal (IN+) and a second non-jumping power terminal (IN-) of the at least three non-jumping power terminals (IN+, IN-, OUT, OUT1) are connected to each end of the bridge arm, respectively;
at least one jumping power terminal (AC, AC1, AC2) at a jumping potential, wherein a first jumping power terminal (AC) of the at least one jumping power terminal (AC, AC1, AC2) is configured to be electrically connected to one terminal of a power inductor (L);
and a third non-jumping power terminal (OUT, OUT1) of the at least three non-jumping power terminals (IN+, IN-, OUT, OUT1) is configured to be electrically connected to the other terminal of the power inductor;
a second capacitor ($C_2$) electrically connected between the third non-jumping power terminal (OUT, OUT1) and one of the other non-jumping power terminals (IN+, IN-) of the at least three non-jumping power terminals (IN+, IN-, OUT, OUT1); and
an auxiliary terminal (OUT2) electrically connected to the third non-jumping power terminal (OUT1) and further configured to be electrically connected to an external capacitor ($C_{X1}$).

**2.** The power module (M) according to claim 1, wherein the first non-jumping power terminal (IN+) is used as a reference point at a reference potential; and
the jumping power terminal has a high-low level jumping with respect to the reference point with a voltage rising rate greater than 10V/$\mu$s, wherein this condition is used as a criterion to define the term of a jumping potential.

**3.** The power module (M) according to claim 2, wherein the non-jumping power terminals (IN+, IN-, OUT, OUT1) are at a fixed potential with respect to the reference point; or have a sinusoidal ripple with a frequency less than 10 kHz with respect to the reference point with the voltage rising rate less than 2V/$\mu$s; or are provided with an AC voltage with a frequency less than 10KHz with respect to the reference point, wherein these conditions are used as criteria to define the term of a non-jumping potential.

**4.** The power module (M) according to claim 2, wherein the first capacitor ($C_1$) and the second capacitor ($C_2$) are high frequency capacitors.

**5.** The power module (M) according to claim 1, wherein the value of the second capacitor ($C_2$) is greater than 1nF.

**6.** The power module (M) according to any one of the preceding claims, wherein the second capacitor ($C_2$) is a Surface Mount Capacitor (SMC) or a capacitor die.

7. The power module (M) according to any one of the preceding claims, wherein the power module (M) is a high frequency switching power module.

8. The power module (M) according to claim 1, wherein the first jumping power terminal (AC) of the at least one jumping power terminal is a center point of the bridge arm.

9. The power module (M) according to any one of the preceding claims, wherein the at least three non-jumping power terminals (IN+, IN-, OUT, OUT1) further includes a fourth non-jumping power terminal (COM), wherein at least one third capacitor ($C_3$) is electrically connected between the fourth non-jumping power terminal (COM) and at least one of other non-jumping power terminals (IN+, IN-) excluding the third non-jumping power terminal (OUT, OUT1) among the at least three non-jumping power terminals (IN+, IN-, OUT, OUT1).

10. The power module (M) according to any one of claims 1 to 8, wherein the at least three non-jumping power terminals (IN+, IN-, OUT, OUT1) further includes a fifth non-jumping power terminal (OUT2), the fifth non-jumping power terminal and the third non-jumping power terminal (OUT, OUT1) being electrically connected, in order to better optimize the effect of EMI.


**Patentansprüche**

1. Leistungsmodul (M), das aufweist:

   einen Brückenarm, der mehrere Leistungseinrichtungen ($Q_1$, $Q_2$; $Q_3$, $Q_4$) enthält, die in Reihe geschaltet sind;
   einen ersten Kondensator (C1), der parallel mit dem Brückenarm angeschlossen ist;
   zumindest drei nicht überspringende Leistungsanschlüsse (IN+, IN-, OUT, OUT1) bei einem nicht überspringenden Potential, wobei ein erster nicht überspringender Leistungsanschluss (IN+) und ein zweiter nicht überspringender Leistungsanschluss (IN-) von den zumindest drei nicht überspringenden Leistungsanschlüssen (IN+, IN-, OUT, OUT1) jeweils an jedes Ende von dem Brückenarm angeschlossen ist;
   zumindest einen überspringenden Leistungsanschluss (AC, AC1, AC2) bei einem überspringenden Potential, wobei ein erster springender Leistungsanschluss (AC) von dem zumindest einen überspringenden Leistungsanschluss (AC, AC1, AC2) konfiguriert ist, um elektrisch an einen Anschluss von einer Leistungsinduktivität (L) angeschlossen zu sein;
   ein dritter nicht überspringender Leistungsanschluss (OUT, OUT1) von den zumindest drei nicht überspringenden Leistungsanschlüssen (IN+, IN-, OUT, OUT1) ist konfiguriert, um elektrisch an den anderen Anschluss von der Leistungsinduktivität angeschlossen zu sein;
   einen zweiten Kondensator (C2), der elektrisch zwischen dem dritten nicht überspringenden Leistungsanschluss (OUT, OUT1) und einem von den anderen nicht überspringenden Leistungsanschlüssen (IN+, IN-) von den zumindest drei nicht überspringenden Leistungsanschlüssen (IN+, IN-, OUT, OUT1) angeschlossen ist; und
   einen Hilfsanschluss (OUT2), der elektrisch an den dritten nicht überspringenden Leistungsanschluss (OUT1) angeschlossen ist und ferner konfiguriert ist, um elektrisch an einen externen Kondensator (Cx1) angeschlossen zu sein.

2. Leistungsmodul (M) gemäß Anspruch 1, wobei der erste nicht überspringende Leistungsanschluss (IN+) als ein Bezugspunkt bei einem Bezugspotential verwendet wird; und
   der überspringende Leistungsanschluss hat einen Hoch-Niedrig-Übersprungspegel im Hinblick auf den Bezugspunkt mit einer Spannungsanstiegsrate, die größer als 10 V/µs ist, wobei diese Bedingung als ein Kriterium verwendet wird, um den Ausdruck von einem Übersprungspotential zu definieren.

3. Leistungsmodul (M) gemäß Anspruch 2, wobei die nicht überspringenden Leistungsanschlüsse (IN+, IN-, OUT, OUT1) bei einem festen Potential im Hinblick auf den Bezugspunkt sind;

   oder eine Welligkeit mit einer Frequenz von weniger als 10 KHz im Hinblick auf den Bezugspunkt mit der Spannungsanstiegsrate von geringer als 2 V/µs hat;
   oder mit einer AC-Spannung mit einer Frequenz von weniger als 10 KHz im Hinblick auf den Bezugspunkt versehen sind, wobei diese Bedingungen als Kriterien verwendet werden, um den Ausdruck von einem nicht überspringenden Potential zu definieren.

4. Leistungsmodul (M) gemäß Anspruch 2, wobei der erste Kondensator (C1) und der zweite Kondensator (C2) Hochfrequenzkondensatoren sind.

5. Leistungsmodul (M) gemäß Anspruch 1, wobei der Wert von dem zweiten Kondensator (C2) größer als 1nF ist.

6. Leistungsmodul (M) gemäß irgendeinem der vorstehenden Ansprüche, wobei der zweite Kondensator (C2) ein Oberflächenmontagekondensator (SMC) oder ein Kondensator-Chip ist.

7. Leistungsmodul (M) gemäß irgendeinem der voranstehenden Ansprüche, wobei das Leistungsmodul (M) ein Hochfrequenzschaltungs-Leistungsmodul ist.

8. Leistungsmodul (M) gemäß Anspruch 1, wobei der erste überspringende Leistungsanschluss (AC) von dem zumindest einen überspringenden Leistungsanschluss ein zentraler Punkt von dem Brückenarm ist.

9. Leistungsmodul (M) gemäß irgendeinem der voranstehenden Ansprüche, wobei die zumindest drei nicht überspringenden Leistungsanschlüsse (IN+, IN-, OUT, OUT1) ferner einen vierten nicht überspringenden Leistungsanschluss (COM) enthalten, wobei zumindest ein dritter Kondensator (C3) elektrisch zwischen dem vierten nicht überspringenden Leistungsanschluss (COM) und zumindest einem von den anderen nicht überspringenden Leistungsanschlüssen (IN+, IN-) angeschlossen ist, ausgenommen dem dritten nicht überspringenden Leistungsanschluss (OUT, OUT1) unter den zumindest drei nicht überspringenden Leistungsanschlüssen (IN+, IN-, OUT, OUT1).

10. Leistungsmodul (M) gemäß irgendeinem der Ansprüche 1 bis 8, wobei die zumindest drei nicht überspringenden Leistungsanschlüsse (IN+, IN-, OUT, OUT1) ferner einen fünften nicht überspringenden Leistungsanschluss (OUT2) enthalten, wobei der fünfte nicht überspringende Leistungsanschluss und der dritte nicht überspringende Leistungsanschluss (OUT, OUT1) elektrisch verbunden sind, um den Effekt des EMI besser zu optimieren.


**Revendications**

1. Module électrique (M), comprenant :

   un bras pont incluant de multiples dispositifs électriques ($Q_1$, $Q_2$; $Q_3$, $Q_4$) connectés en série ;
   un premier condensateur ($C_1$) connecté en parallèle au bras pont ;
   au moins trois bornes électriques non sautantes (IN+, IN-, OUT, OUT1) à un potentiel non sautant, dans lequel une première borne électrique non sautante (IN+) et une deuxième borne électrique non sautante (IN-) des au moins trois bornes électriques non sautantes (IN+, IN-, OUT, OUT1) sont connectées à chaque extrémité du bras pont, respectivement ;
   au moins une borne électrique sautante (AC, AC1, AC2) à un potentiel sautant, dans lequel une première borne électrique sautante (AC) de l'au moins une borne électrique sautante (AC, AC1, AC2) est configurée pour être électriquement connectée à une borne d'un inducteur électrique (L) ;
   et une troisième borne électrique non sautante (OUT, OUT1) des au moins trois bornes électriques non sautantes (IN+, IN-, OUT, OUT1) est configurée pour être électriquement connectée à l'autre borne de l'inducteur électrique ;
   un deuxième condensateur ($C_2$) électriquement connecté entre la troisième borne électrique non sautante (OUT, OUT1) et une des autres bornes électriques non sautantes (IN+, IN-) des au moins trois bornes électriques non sautantes (IN+, IN-, OUT, OUT1) ; et
   une borne auxiliaire (OUT2) électriquement connectée à la troisième borne électrique non sautante (OUT1) et en outre configurée pour être électriquement connectée à un condensateur externe ($C_{X1}$).

2. Module électrique (M) selon la revendication 1, dans lequel la première borne électrique non sautante (IN+) est utilisée en tant que point de référence à un potentiel de référence ; et
   la borne électrique sautante a un saut de niveau haut-bas par rapport au point de référence avec un taux d'augmentation de tension supérieur à 10V/$\mu$s dans lequel cette condition est utilisée en tant que critère pour définir le terme d'un potentiel sautant.

3. Module électrique (M) selon la revendication 2, dans lequel les bornes électriques non sautantes (IN+, IN-, OUT, OUT1) sont à un potentiel fixe par rapport au point de référence ; ou ont une ondulation sinusoïdale avec une fréquence inférieure à 10 kHz par rapport au point de référence avec le taux d'augmentation de tension inférieur à 2V/$\mu$s ; ou sont alimentées en tension CA avec une fréquence inférieure à 10 KHz par rapport au point de référence, dans lequel ces conditions sont utilisées en tant que critères pour définir le terme d'un potentiel non sautant.

4. Module électrique (M) selon la revendication 2, dans lequel le premier condensateur ($C_1$) et le deuxième condensateur ($C_2$) sont des condensateurs haute fréquence.

5. Module électrique (M) selon la revendication 1, dans lequel la valeur du deuxième condensateur ($C_2$) est supérieure à 1nF.

6. Module électrique (M) selon l'une quelconque des revendications précédentes, dans lequel le deuxième condensateur ($C_2$) est un condensateur pour montage en surface (SMC) ou une puce de condensateur.

7. Module électrique (M) selon l'une quelconque des revendications précédentes, dans lequel le module électrique (M) est un module électrique à commutation haute fréquence.

8. Module électrique (M) selon la revendication 1, dans lequel la première borne électrique sautante (AC) de l'au moins une borne électrique sautante est un point central du bras pont.

9. Module électrique (M) selon l'une quelconque des revendications précédentes, dans lequel les au moins trois bornes électriques non sautantes (IN+, IN-, OUT, OUT1) inclut en outre une quatrième borne électrique non sautante (COM), dans lequel au moins un troisième condensateur ($C_3$) est électriquement connecté entre la quatrième borne électrique non sautante (COM) et au moins une d'autre bornes électriques non sautantes (IN+, IN-) à l'exclusion de la troisième borne électrique non sautante (OUT, OUT1) parmi les au moins trois bornes électriques non sautantes (IN+, IN-, OUT, OUT1).

10. Module électrique (M) selon l'une quelconque des revendications 1 à 8, dans lequel les au moins trois bornes électriques non sautantes (IN+, IN-, OUT, OUT1) inclut en outre une cinquième borne électrique non sautante (OUT2), la cinquième borne électrique non sautante et la troisième borne électrique non sautante (OUT, OUT1) étant électriquement connectées afin de mieux optimiser l'effet d'EMI.

Fig. 1

Fig. 2

Fig. 3

Fig. 4

Fig. 5

Fig. 6a          Fig. 6b          Fig. 6c

Fig. 7

Fig. 8

Fig. 9a                    Fig. 9b

Fig. 9c              Fig. 9d              Fig. 9e

Fig. 9f

Fig. 9g

Fig. 9h

Fig. 10

## REFERENCES CITED IN THE DESCRIPTION

**Patent documents cited in the description**

- US 20180205309 A1
- JP 2009296798 A
- JP 2003168586 A
- US 2012262953 A1
- CN 107769569 A
- US 2008112121 A1